# EUROPEAN PATENT APPLICATION

(11) **EP 2 468 919 A1**
(43) Date of publication of application: **27.06.2012**
(21) Application number: 11195161.2
(22) Date of filing: 22.12.2011
(51) Int. Cl.: C23C 14/32, C23C 14/16, C23C 14/04, C23C 14/34, F01D 5/00, B23P 6/00, F01D 5/28

(54) **Cathodic arc vapor deposition coatings for dimensional restoration of surfaces**

(30) Priority: 23.12.2010 US 201013426680; 19.12.2011 US 201113329599
(71) Applicant: United Technologies Corporation, Hartford, CT 06101 (US)
(72) Inventor: Ivory, Steven, Ashford, CT Connecticut 06278 (US); Tryon, Brian S., Glastonbury, CT Connecticut 06033 (US); Bogue, William, Hebron, CT Connecticut 06248 (US)
(74) Representative: Leckey, David Herbert

(57) **Abstract**

A process for repairing a workpiece (12) includes the steps of: providing a workpiece (12) having at least one interior surface (11) requiring restoration; providing a source (12) of repair material; and depositing the repair material onto the at least one interior surface (11) using a technique which is a near non-line of sight technique.

## Description

### BACKGROUND

The present disclosure relates to a process for dimensionally restoring surfaces on a workpiece using a near non-line of sight technique such as cathodic arc vapor deposition technique.

Cathodic arc deposition was developed to apply simple coatings, such as titanium nitride, as a hard coat for workpieces such as drill bits. Cathodic arc deposition has been used to apply wear resistant and corrosion resistant coating systems on workpieces.

In use, some workpieces, such as turbine engine components, suffer loss of desired dimensions. It thus becomes necessary to repair them by performing dimensional restoration. Conventional thermal sprays require moderate to near-normal angle of approach to the substrate to achieve adherence, limiting applications where only shallow angle of approach is available. Such repairs have been difficult to perform on certain portions of the workpieces with limited line-of-sight (LLOS) such as hook attachments, seal grooves, and bolt holes. Current methods for LLOS dimensional restoration are restricted to plating processes or recoil directed thermal sprays. Plating materials with high temperature capability such as those operating at temperatures greater than 1000°F (538°C), are not commercially available. Choice of plating materials for titanium is much more restricted. Welding is frequently not an option because of mechanical property debits and distortion.

Near non-line of sight (NLOS) dimensional restoration approaches for repair are currently dominated by plating processes; however, electroless nickel, electrolytic nickel and chrome (Cr-III or Cr-VI) plates are limited on parts with service temperatures over 800°F (427°C) for chrome and electroless nickel and to 1000°F (538°C) for electrolytic nickel.

Certain bolts used on turbine engines are used to align and tie the high pressure compressor cases together. These are press-installed into tight tolerance, heavily loaded holes in each stage case. These holes can wear beyond limits with no known repair other than flange replacement. Local weld repair of the holes induces too much distortion on the other holes in the flange or leaves unacceptable levels of residual stress and fatigue property debit from the weld process.

Repair of worn and damaged cases with seal slot lands requires removal of the rear flange to access the repair area with plasma spray. The flange is subsequently restored by electron beam welding on a new flange. Such repairs have had limited success because the post-weld heat treatment frequently results in irreparable distortion. Vane hooks are similarly weld repaired when worn but may not have sufficient strength after extensive weld repair.

Other applications push the acceptable temperature limits of nickel plate, but only at reduced allowable stresses on the plate. These include diffuser case stator hooks and turbine disk shoulder snap diameters. Also note that use of chrome plate is increasingly hampered by EH&S restrictions world-wide and its viability as a repair technique is more and more becoming a method of last resort.

### SUMMARY

Cathodic arc vapor deposition provides an alternative approach for performing dimensional restoration of a part, such as a hole, in a case used on a turbine engine. In particular, cathodic arc vapor deposition enables one to coat down the sides of the holes or to both faces of a hook. Further, coating down the inner diameter of tubes is also possible, particularly where the restoration of material near the end of the tube where the largest wear takes place is of concern.

In accordance with the present disclosure, there is provided a process for repairing a workpiece which broadly comprises the steps of: providing a workpiece having at least one interior surface requiring restoration; providing a source of repair material; and depositing the repair material onto the at least one interior surface using a technique which is a near non-line of sight technique. Other details of the cathodic arc vapor deposition coatings for dimensional restoration of surfaces are set forth in the following detailed description and the accompanying drawings wherein like reference numerals depict like elements.

### BRIEF DESCRIPTION OF THE DRAWINGS

Fig. 1 is a schematic representation of a cathodic arc vapor deposition apparatus being used to coat a hole in a workpiece;
Fig. 2 is a schematic representation showing a mask placed over a portion of the workpiece;
Figs. 3(a) - 3(i) are photomicrographs showing build-up of a coating along a hole area in a diffuser case.

### DETAILED DESCRIPTION

Cathodic arc vapor deposition is a method of applying coatings that do not require full line of sight. Cathodic arc vapor deposition can coat areas not accessible via thermal spray coatings and can apply coatings that result in little or no base material debit. Cathodic arc vapor deposition can coat parts to near-net shapes without requiring subsequent machining. Cathodic arc can be applied without introducing structural lifing debits as part of the surface preparation or coating processes.

While cathodic arc vapor deposition has been used as a means to install wear resistant and corrosion resistant coatings onto a surface of smaller parts in OEM, cathodic arc vapor deposition has not been used in repair techniques for dimensional restoration of an object. The LLOS advantages of cathodic arc coating have not yet been utilized.

Cathodic arc vapor deposition is a process which uses electrical biasing and inert gas pressure to enhance coverage to include areas of limited accessibility or that lack line-of-sight. Coating composition is flexible and can be made from any material. Coatings are fully dense and metallurgically bonded with bond strength capability in excess of 9 ksi. Coating compositions have an operating temperature capability equal to or better than base alloy substrate.

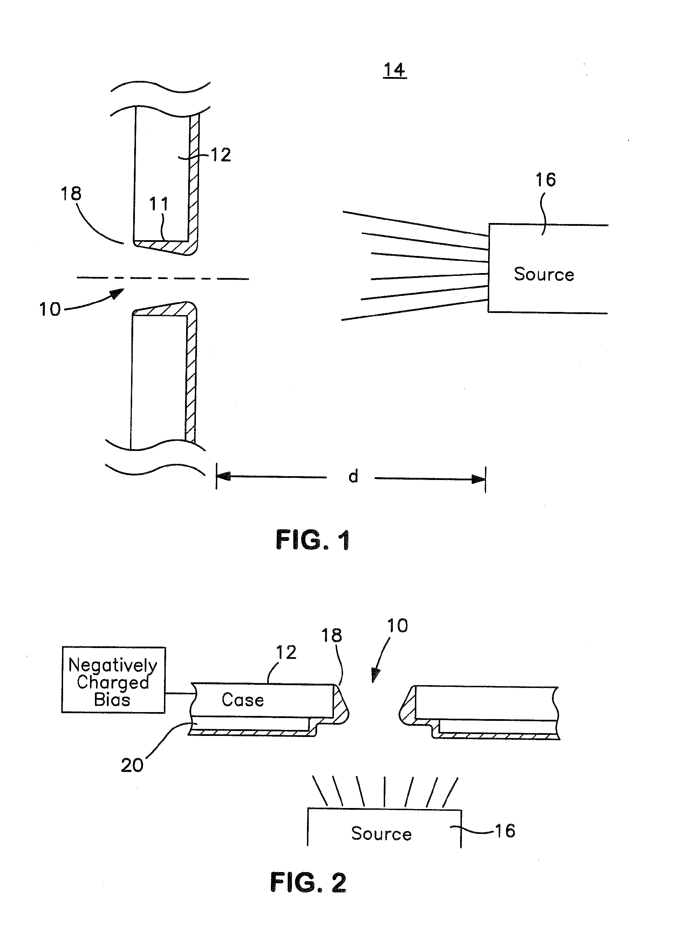

As shown in Fig. 1, cathodic arc vapor deposition can be used to restore the dimensions of a workpiece, such as the walls 11 of a hole 10 in a case 12. The hole 10 may have a diameter less than 0.25 inches (6.35 mm). The case 12 is placed within a chamber 14 and spaced from a source 16 of the coating material by a distance "d". The distance "d" can be varied as desired. The source 16 is a cathode having an evaporative surface.

Prior to being placed in the chamber 14, the walls 11 and other areas of the workpiece to be coated may be subjected to a treatment to remove any deleterious material, such as engine run contaminants and oxides, and provide a clean surface for the coating.

The coating material forming the source 16 may comprise a supply of any desired coating material. The coating material may comprise a restoration alloy having desirable strength properties, desirable wear properties, desirable lubrication properties, desirable electronic properties, desirable corrosion resistance properties, or a metal which closely matches the metal forming the case 12. By "closely match", it is meant that the restoration alloy is formed of a composition similar to or the same as the parent material from which the case 12 is formed. Examples of such materials include nickel-based alloys, nickel-based superalloys, titanium, titanium-based alloys, cobalt alloys, cobalt superalloys, stainless steels, corrosion resistant steels, i.e. Greek Ascaloy steel, and high temperature steels, i.e. Thermospan steel.

The source/cathode 16 is connected to a negative lead of a direct current power supply (not shown) and the positive lead of the power supply is attached to an anodic member. An inert gas such as Argon is introduced into the chamber 14. An arc-initiating trigger, at or near the same electrical potential as the anode, contacts the cathode and subsequently moves away from the cathode. When the trigger is still in close proximity to the cathode, the difference in electrical potential between the trigger and the cathode causes an arc of electricity to extend therebetween. As the trigger moves further away, the arc jumps between the cathode and the anodic chamber. The cathode material vaporizes into a plasma containing atoms, molecules, ions, electrons, and particles. Positively charged ions liberated from the cathode are attracted toward the negatively charged workpiece 12 and the walls 11 of the hole 10 and are deposited thereon.

The amperage (source) and bias (case) needed to obtain the desired coating 18 down the hole (a limited line of sight), are dependent on "d" and the aspect ratio of the hole being coated.

If desired, as shown in Fig. 2, masking 20 may be added to keep the coating 18 off certain areas of the workpiece or case 12. With masking, no bridging is observed using cathodic arc vapor deposition. The use of masking also enables the restorative build-up to take place only at the intended location, rather than over the entire workpiece.

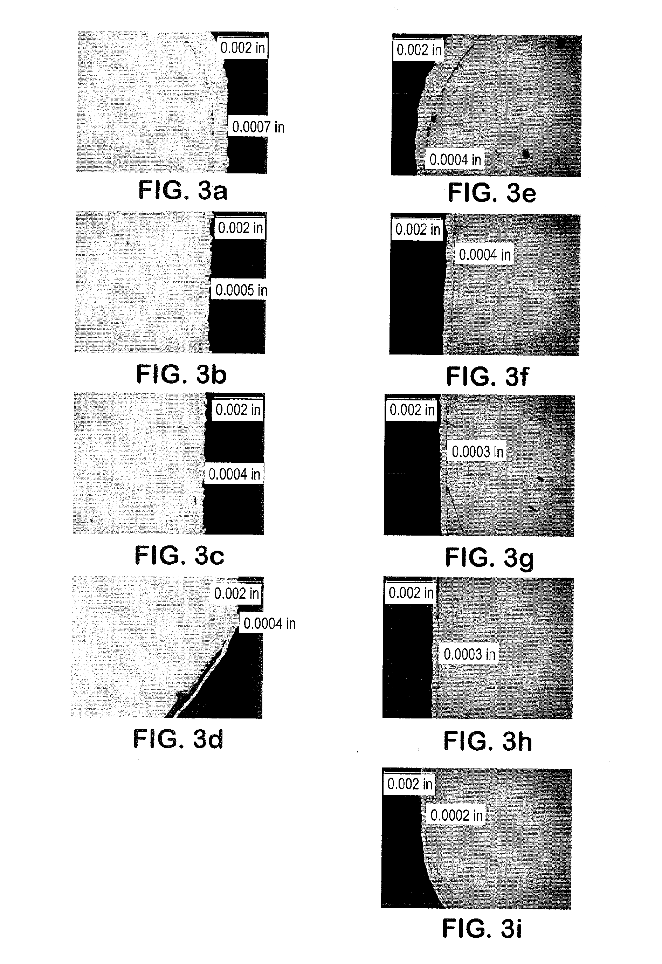

In one test of a cathodic arc vapor deposition repair technique, a hole area in a diffuser case was coated down the sides of a hole. Figs. 3(a) - 3(i) illustrate the coating which was deposited on the sides of the hole using a cathodic arc vapor deposit. Fig. 3(a) and 3(c) show the sides of the hole closest to the source. Figs. 3(d) and 3(i) show the sides of the hole farthest from the source.

Using cathodic arc vapor deposition to effect dimensional repairs has a number of advantages. First, it is a near non-line of sight coating technique. Second, restored materials deposited using this method have a high bond strength. Third, it allows the use of coating materials, such as Stellite-31 base material. Such materials are desirable because they are thermally stable well beyond the highest allowable service temperatures for nickel or chrome plates. Fourth, cathodic arc vapor deposition results in no grit blast fatigue debit like thermal spray coatings and no hydrogen pick-up fatigue debit as per most electrolytic applied plating. Fifth, cathodic arc deposition may allow for as-applied surfaces to be released without subsequent machining.

Use of cathodic arc deposition for dimensional restoration can extend to holes and to hooks, but can also be considered for seal ring grooves such as on turbine seal plates or on bearing housings, i.e. a trough-like shape where out on the sides of the groove is the critical dimension. There is also a potential use as an alternate to Chrome plate.

The cathodic arc repair technique is advantageous in that it can be used to coat holes having a depth greater than 0.060 inches (1.524 mm). Further, it can be used to repair slots in workpieces that have a width less than 0.25 inches (6.35 mm) and/or a depth greater than 0.060 inches (1.524 mm) .

## Claims

1. A process for repairing a workpiece (12) comprising the steps of:
providing a workpiece (12) having at least one interior surface (11) requiring restoration;
providing a source (16) of repair material; and
depositing said repair material onto said at least one interior surface (11) using a near non-line of sight technique.

2. The process of claim 1, further comprising the steps of:
placing said workpiece (12) within a chamber (14); and
spacing said workpiece (12) at a distance from said source (16) of said repair material.

3. The process of claim 2, wherein said technique comprises a cathodic arc deposition technique and wherein said source (16) comprises a cathode having an evaporative surface.

4. The process of claim 2 or 3, further comprising removing deleterious material from said at least one interior surface (11) prior to placing said workpiece in said chamber (14).

5. The process of any preceding claim, wherein said step of providing a repair material source (16) comprises providing a source (16) of material which closely matches a composition of the parent material forming the at least one interior surface (11).

6. The process of any preceding claim, wherein said repair material source providing step comprises providing a material selected from the group of a nickel-based alloy, a nickel-based superalloy, titanium, a titanium-based alloy, a cobalt alloy, a cobalt superalloy, stainless steel, a corrosion resistant steel, and a high temperature steel.

7. The process of any preceding claim, further comprising masking at least one area of the workpiece (12) to prevent deposition of said repair material on said at least one area.

8. The process of any preceding claim, wherein said workpiece providing step comprises providing a part (12) having a hole (10) with said at least one interior surface (11).

9. The process of claim 8, wherein said workpiece providing step comprises providing a case (12) having a hole (10) with said at least one interior surface (11).

10. The process of any of claims 1 to 7, wherein said workpiece (12) comprises a tube and said at least one interior surface (11) comprises at least one interior surface along an inner diameter of said tube and said step of depositing said repair material comprises depositing a coating along said at least one interior surface of said tube.

11. The process of any preceding claim, wherein said depositing step comprises depositing a sufficient amount of repair material to return said at least one interior surface (11) to a near-net shape.
